# EUROPÄISCHE PATENTSCHRIFT

(11) **EP 4 186 775 B1**
(45) Veröffentlichungstag und Bekanntmachung des Hinweises auf die Patenterteilung: **13.03.2024**
(21) Anmeldenummer: 21210630.6
(22) Anmeldetag: 26.11.2021
(51) Int. Cl.: B61L 1/16, B61L 1/14, B61L 25/02, B61L 29/32

(54) **VERFAHREN UND VORRICHTUNG ZUM ERKENNEN VON EIGENSCHAFTEN EINES FAHRZEUGS**
METHOD AND DEVICE FOR DETECTING THE PROPERTIES OF A VEHICLE
PROCÉDÉ ET DISPOSITIF DE DÉTECTION DES PROPRIÉTÉS D'UN VÉHICULE

(43) Veröffentlichungstag der Anmeldung: 31.05.2023
(73) Patentinhaber: Siemens Mobility GmbH, 81739 München (DE)
(72) Erfinder: BRABAND, Jens, 38106 Braunschweig (DE)
(74) Vertreter: Siemens Patent Attorneys

(56) Entgegenhaltungen:
- EP-A1- 1 279 581
- EP-A1- 2 236 387
- ZASOV VALERY A ET AL: "Geometry-Based Rolling-Stock Identification System Insensitive to Speed Variations", 2020 IEEE EAST-WEST DESIGN & TEST SYMPOSIUM (EWDTS), IEEE, 4. September 2020 (2020-09-04), Seiten 1-6, XP033842967, DOI: 10.1109/EWDTS50664.2020.9224911 [gefunden am 2020-10-14]
- MYOUNGGYU WON: "Intelligent Traffic Monitoring Systems for Vehicle Classification: A Survey", ARXIV.ORG, CORNELL UNIVERSITY LIBRARY, 201 OLIN LIBRARY CORNELL UNIVERSITY ITHACA, NY 14853, 10. Oktober 2019 (2019-10-10), XP081513641,

## Beschreibung

Die Erfindung betrifft Verfahren zum Erkennen von Eigenschaften eines spurgeführten Fahrzeugs, bei dem ein Achszähler während der Überfahrt des spurgeführten Fahrzeugs Messdaten erfasst, rechnergestützt die Messdaten analysiert und dabei eine Geschwindigkeit und Achsabstände des Fahrzeugs ermittelt werden und rechnergestützt anhand der ermittelten Geschwindigkeit und der ermittelten Achsabstände eine Eigenschaft des spurgeführten Fahrzeugs ermittelt wird. Außerdem betrifft die Erfindung Vorrichtung zur Bestimmung von Eigenschaften von spurgeführten Fahrzeugen, umfassend mindestens einen Achszähler zum Erfassen von Messdaten bei Überfahrt der Fahrzeuge und einen Computer, der eingerichtet ist, die Messdaten zu analysieren und dabei eine Geschwindigkeit und Achsabstände des Fahrzeugs zu ermitteln, sowie anhand der ermittelten Geschwindigkeit und der ermittelten Achsabstände eine Eigenschaft des Fahrzeugs (FZ) zu ermitteln. Zuletzt betrifft die Erfindung ein Computerprogrammprodukt sowie eine Bereitstellungsvorrichtung für dieses Computerprogrammprodukt, wobei das Computerprogrammprodukt mit Programmbefehlen zur Durchführung dieses Verfahrens ausgestattet ist.

Die klassische Sicherungstechnik im Bahnbetrieb erkennt viele Eigenschaften von spurgeführten Fahrzeugen (im Folgenden auch Schienenfahrzeug oder Zug genannt) nicht, wie zum Beispiel die Gattung eines Zuges (z. B. Güterzug, Regionalzug, Lokomotive usw.), sondern kennt nur logische Eigenschaften, zum Beispiel die Belegung eines Gleisfreimeldeabschnitts. Die Betriebsleittechnik kennt andererseits diese Gattung und ggf. weitere Eigenschaften des Zuges, diese können aber in der Regel nicht für sichere Entscheidungen zugrunde gelegt werden, weil sie selbst nicht das erforderliche Sicherheitsniveau aufweisen. Dennoch ist es für den Zugbetrieb in bestimmten Betriebssituationen erforderlich, die Zuggattung mit dem erforderlichen Sicherheitsniveau festzustellen. Dies passiert heute durch eine Mischung technischer und betrieblicher Verfahren, teils mit erheblichem Aufwand. Zuggattungen, in der Schweiz Zugkategorie genannt, sind Kategorien unterschiedlicher Eisenbahnzüge. Die Einteilung der Züge erfolgt mit Rücksicht auf ihre Benutzung, nach ihrer Bedeutung für den Verkehr und auf Grund ihrer fahrdienstlichen Behandlung. Jeder Zug wird durch die Zuggattung und eine Zugnummer bezeichnet.

Die Bezeichnungen für die Zuggattungen variieren; so gibt es neben den umgangssprachlichen Bezeichnungen auch fachsprachliche Benennungen, und zwar verkehrswissenschaftliche Begriffe, aus der Zeit der Staatsbahnen über Vorschriften entstandene Bezeichnungen sowie Markennamen der Eisenbahnverkehrsunternehmen. Unabhängig davon, welche Zuggattungen verwendet werden, ermöglichen diese jedoch genauere Angaben zu den verkehrenden Zügen zu machen. Diese können beispielsweise in einem Bahnautomatisierungssystem abgespeichert sein und zu Steueraufgaben herangezogen werden. Dokument EP 2 718 168 B1 betrifft ein Verfahren zum Betreiben einer Eisenbahnsicherungsanlage mit mindestens einer Streckeneinrichtung unter Berücksichtigung einer beim Einfahren des Schienenfahrzeugs in die Einschaltstrecke der Eisenbahnsicherungsanlage erfassten Geschwindigkeitsmessgröße. Beim Einfahren des Schienenfahrzeugs in die Einschaltstrecke anhand der Geschwindigkeitsmessgröße wird überprüft, ob eine Korrekturzeit für die Weiterleitung einer Meldung von der einen Streckeneinrichtung an eine zugeordnete Eisenbahnsicherungsanordnung entsprechend der Geschwindigkeitsmessgröße einzustellen ist. Danach wird eine eingestellte Korrekturzeit dahingehend überprüft, ob diese in Abhängigkeit von mindestens einer weiteren fahrzeitbestimmenden Einflussgröße des Schienenfahrzeugs wirksam bleiben soll.

Dokument ZASOV VALERY A ET AL, Geometry-Based Rolling-Stock Identification System Insensitive to Speed Variations, 2020 IEEE EAST-WEST DESIGN & TEST SYMPOSIUM (EWDTS), IEEE definiert ein Verfahren zur Bestimmung einer Zuggattung durch Messung des Radstands und der Geschwindigkeit jeder Achse mit Raddetektoren.

Die Aufgabe der Erfindung besteht darin, mit geringem Aufwand (zum Beispiel möglichst ohne zusätzlich zu installierende Sensorik, mit geringem Rechenaufwand hinsichtlich Hardware und Software) die Gattung des Zuges genügend sicher zu erkennen, damit die erkannte Zuggattung in der Sicherungstechnik des Bahnbetrieb Verwendung finden kann. Zu diesem Zweck soll ein Verfahren und eine zur Anwendung des Verfahrens geeignete Vorrichtung angegeben werden. Außerdem besteht die Aufgabe der Erfindung darin, ein Computerprogrammprodukt sowie eine Bereitstellungsvorrichtung für dieses Computerprogrammprodukt anzugeben, mit dem das vorgenannte Verfahren durchgeführt werden kann.

Diese Aufgabe wird mit dem eingangs angegebenen Anspruchsgegenstand (Verfahren) erfindungsgemäß dadurch gelöst, dass in einem Prüfungsschritt ein Muster von Normalachsabständen ermittelt wird, indem jedem der ermittelten Achsabstände ein unter Berücksichtigung einer vorgegebenen Normalgeschwindigkeit berechneter Normalachsabstand zugeordnet wird, und die Normalachsabstände unter Berücksichtigung ihrer Reihenfolge zu dem Muster zusammengefügt werden, das Muster mit Referenzmustern verglichen wird und im Falle einer erkannten Übereinstimmung des Musters mit einem Referenzmuster dem Fahrzeug eine mit dem Referenzmuster verknüpfte Gattung als Eigenschaft zugeordnet wird.

Erfindungsgemäß ist mit anderen Worten vorgesehen, aus den Rohdaten des Achszählers während der Überfahrt die Abstände der Achsen des Zugverbands zu bestimmen. Insbesondere Personenzüge wie ICE oder Regionalzüge bestehen aus festen Einheiten, die in der Regel zusammenbleiben, aus denen keine Wagen ausgekuppelt werden. Deswegen gibt es Muster, die durch Koppelung dieser Einheiten mehrfach hintereinander gemessen werden können und die einander ähnlich sind. Außerdem ergibt der Zug in seiner Gesamtheit ein für diesen typisches Muster. Personenzüge haben damit sozusagen einen festen "Fingerabdruck", der nur durch Messfehler etc. verändert wird.

Der Vorteil der Nutzung einer Mustererkennung im Zugbetrieb liegt darin begründet, dass Parameter des Zugbetriebs wie beispielsweise Schließzeiten eines Bahnübergangs oder Streckenfreigaben flexibel an die aufgrund der Mustererkennung der untersuchten Eigenschaft zugeordneten Fahrzeuge angepasst werden können. Hierdurch ist beispielsweise eine größere Streckenauslastung zu erreichen. Ein anderes Beispiel ist die zuverlässige Erkennung von Gefahrenschwerpunkten, für die Sicherungsmaßnahmen eingeleitet werden können.

Dagegen gibt es bei Güterzügen andere, in der Regel variable und damit nicht ähnliche oder identische Muster, je nachdem welche und wie viele Einheiten zusammengekuppelt werden (das Muster eines Güterzuges als ganzes kann aber erkannt werden) . Damit lassen die Daten als mehrdimensionale Vektoren darstellen, deren Komponenten die Abstände zwischen den Achsen repräsentieren, d. h. Achse 1 zu Achse 2 bis hin zu Achse n-1 zu Achse n (bei n Achsen des Zuges, in der Realität bis zu 250).

Die Begriffe identisch (identical) und ähnlich (similar) sollen in ihrer Bedeutung im Sinne der Mustererkennung begriffen werden. Dies bedeutet, dass ein Vergleich von Mustern dazu führen kann, dass diese als identisch oder ähnlich (oder eben nicht als identisch und nicht ähnlich, also nicht verwandt) bewertet werden. Diese Bewertung erfolgt vorzugsweise rechnergestützt.

Als identisch werden Muster begriffen, wenn alle Prüfkriterien beim Mustervergleich zu dem Ergebnis führen, dass eine Übereinstimmung der Prüfkriterien vorliegt. Da die Prüfkriterien auf Messwerten beruhen, kann hierbei ein Toleranzintervall für die Messung festgelegt werden, innerhalb dessen das Prüfkriterium liegen kann, um als identisch begriffen zu werden.

Als ähnlich werden Muster begriffen, wenn eine Auswertung der Prüfkriterien ergibt, dass diese zumindest größtenteils einander entsprechen. Hierbei ist anzumerken, dass Ähnlichkeit somit auch vorliegt, wenn die Muster identisch sind.

Wann die Frage bejaht werden kann, dass die Kriterien zumindest größtenteils einander entsprechen, muss für die Durchführung der Mustererkennung festgelegt werden. Allgemein gilt hierbei für die Erkennung der genannten Eigenschaft folgender Zusammenhang. Je strenger die Kriterien für die Erkennung von Ähnlichkeit sind, desto größer ist die Wahrscheinlichkeit, dass die erkannten ähnlichen Muster tatsächlich immer zu Erkennung der richtigen Zuggattung führen. Je weniger streng die Kriterien für die Erkennung von Ähnlichkeit sind, desto höher ist die Wahrscheinlichkeit, dass eine Zuggattung falsch erkannt wird.

Unabhängig von der Strenge der Kriterien funktioniert das erfindungsgemäße Verfahren im technischen Sinne. Im Betrieb ist allerdings zu ermitteln, wo hinsichtlich der Strenge der Kriterien in Bezug auf einen sicheren Betrieb ein Optimum liegt (zur Festlegung der Kriterien im Folgenden noch mehr).

Ein für die Erfindung wesentlicher Aspekt, der die Erkennung von identischen oder ähnlichen Mustern erschwert, ist darin zu sehen, dass die Fahrzeuge den Achszähler mit unterschiedlichen Geschwindigkeiten überqueren können. Dies wirkt sich, wie im Folgenden noch näher erläutert wird, auf den durch den Achszähler gemessenen Signalverlauf aus. Um diesen Effekt zu eliminieren, wird erfindungsgemäß die Normalgeschwindigkeit definiert. Diese wird für das Verfahren festgelegt, wobei der Betrag der Geschwindigkeit frei gewählt werden kann (dann aber festgelegt ist) .

Werden die gemessenen Signale jetzt anhand der Normalgeschwindigkeit normiert, so lässt sich das Muster aus Normalabständen berechnen, die für die Normalgeschwindigkeit gelten. Dieses Muster kann dann mit einem ebenfalls für diese Normalgeschwindigkeit erstellten Referenzmuster verglichen werden. Dieses Referenzmuster kann vorteilhaft für einen Vergleich der aus den Normalabständen berechneten Muster unabhängig von der Geschwindigkeit des den Achszähler überfahrenen Fahrzeugs herangezogen werden. Die Information, die in dem Signal über die Zuggattung enthalten ist, wird nämlich bei unterschiedlichen Geschwindigkeiten nicht verändert, sondern durch die Geschwindigkeit nur gestaucht bzw. gestreckt. Mathematisch gesehen ist die im Achszählsignal enthaltene Information damit invariant gegenüber Geschwindigkeitsänderungen.

Dadurch, dass für einen bestimmten Zug bzw. eine bestimmte Zuggattung nur ein Referenzmuster zur Verfügung gestellt werden muss, um einen Abgleich mit den aus den Normalabständen gewonnenen Mustern zu ermöglichen, verringert sich vorteilhaft der Einsatz von Speicherkapazität sowie der Rechenaufwand beim Vergleich der Muster mit dem Referenzmuster. Das erfindungsgemäße Verfahren kann daher besonders effizient durchgeführt werden. Außerdem ist die Konfiguration der Rechenumgebung, in der das Verfahren abläuft, schneller und einfacher abzuschließen, was im Betrieb einen Gewinn an Wirtschaftlichkeit bringt (hierzu im Folgenden noch mehr).

Die Referenzmuster können beispielsweise in einer Speichereinrichtung abgelegt sein. Ein Server kann die Referenzmuster zur Verfügung stellen, damit ein Vergleich mit den ermittelten Mustern ermöglicht wird. Eine andere Möglichkeit besteht darin, dass die Referenzmuster in einer Speichereinrichtung abgelegt sind, die einen Bestandteil des Achszählers bildet. So entsteht die Möglichkeit, die Achszähler mit einer gewissen Intelligenz, mit anderen Worten als autark oder teilweise autark agierende Einheiten technisch zu modifizieren.

Der Vorteil darin, dass Referenzmuster in einer Speichereinrichtung abgelegt sind, liegt darin, dass diese jederzeit zur Verfügung stehen und bei Bedarf ohne Zeitverzögerung abgerufen werden können. Die Speichereinrichtungen können die verschiedenen Referenzmuster auch streckenspezifisch abspeichern, sodass bestimmten Achszählern an bestimmten Streckenabschnitten auch nur bestimmte Referenzmuster zur Verfügung gestellt werden.

Unter "rechnergestützt" oder "computerimplementiert" kann im Zusammenhang mit der Erfindung eine Implementierung des Verfahrens verstanden werden, bei dem mindestens ein Computer oder Prozessor mindestens einen Verfahrensschritt des Verfahrens ausführt.

Der Ausdruck "Rechner" oder "Computer" deckt alle elektronischen Geräte mit Datenverarbeitungseigenschaften ab. Computer können beispielsweise Personal Computer, Server, Handheld-Computer, Mobilfunkgeräte und andere Kommunikationsgeräte, die rechnergestützt Daten verarbeiten, Prozessoren und andere elektronische Geräte zur Datenverarbeitung sein, die vorzugsweise auch zu einem Netzwerk zusammengeschlossen sein können.

Unter einem "Prozessor" kann im Zusammenhang mit der Erfindung beispielsweise einen Wandler einen Sensor zur Erzeugung von Messsignalen oder eine elektronische Schaltung, verstanden werden. Bei einem Prozessor kann es sich insbesondere um einen Hauptprozessor (engl. Central Processing Unit, CPU), einen Mikroprozessor, einen Mikrocontroller, oder einen digitalen Signalprozessor, möglicherweise in Kombination mit einer Speichereinheit zum Speichern von Programmbefehlen, etc. handeln. Auch kann unter einem Prozessor ein virtualisierter Prozessor oder eine Soft-CPU verstanden werden.

Unter einer "Speichereinheit" kann im Zusammenhang mit der Erfindung beispielsweise ein computerlesbarer Speicher in Form eines Arbeitsspeichers (engl. Random-Access Memory, RAM) oder Datenspeichers (Festplatte oder Datenträger) verstanden werden.

Als "Schnittstellen" können hardwaretechnisch, beispielsweise kabelgebunden oder als Funkverbindung, und/oder softwaretechnisch, beispielweise als Interaktion zwischen einzelnen Programmmodulen oder Programmteilen eines oder mehrerer Computerprogramme, realisiert sein.

Als "Cloud" soll eine Umgebung für ein "Cloud-Computing" (deutsch Rechnerwolke oder Datenwolke) verstanden werden. Gemeint ist eine IT-Infrastruktur, welche über Schnittstellen eines Netzwerks wie das Internet verfügbar gemacht wird. Sie beinhaltet in der Regel Speicherplatz, Rechenleistung oder Software als Dienstleistung, ohne dass diese auf dem die Cloud nutzenden lokalen Computer installiert sein müssen. Die im Rahmen des Cloud-Computings angebotenen Dienstleistungen umfassen das gesamte Spektrum der Informationstechnik und beinhaltet unter anderem Infrastruktur, Plattformen und Software.

Als "Programmmodule" sollen einzelne Funktionseinheiten verstanden werden, die einen erfindungsgemäßen Programmablauf von Verfahrensschritten ermöglichen. Diese Funktionseinheiten können in einem einzigen Computerprogramm oder in mehreren miteinander kommunizierenden Computerprogrammen verwirklicht sein. Die hierbei realisierten Schnittstellen können softwaretechnisch innerhalb eines einzigen Prozessors umgesetzt sein oder hardwaretechnisch, wenn mehrere Prozessoren zum Einsatz kommen.

Sofern es in der nachfolgenden Beschreibung nicht anders angegeben ist, beziehen sich die Begriffe "erstellen", "feststellen", "berechnen", "generieren", "konfigurieren", "modifizieren" und dergleichen vorzugsweise auf Prozesse, die Daten erzeugen und/oder verändern und/oder die Daten in andere Daten überführen. Dabei liegen die Daten insbesondere als physikalische Größen vor, beispielsweise als elektrische Impulse oder auch als Messwerte. Die erforderlichen Anweisungen Programmbefehle sind in einem Computerprogramm als Software zusammengefasst. Weiterhin beziehen sich die Begriffe "senden", "empfangen", "einlesen", "auslesen", "übertragen" und dergleichen auf das Zusammenspiel einzelner Hardwarekomponenten und/oder Softwarekomponenten über Schnittstellen.

Gemäß einer Ausgestaltung der Erfindung ist vorgesehen, dass jeder der Achsabstände unter Berücksichtigung einer für den betreffenden Achsabstand geltenden Einzelgeschwindigkeit des Fahrzeugs ermittelt wird.

Wenn man als Verallgemeinerung Beschleunigungen bei der Messung zulässt, so kann man näherungsweise die Beschleunigung zwischen zwei benachbarten Rädern als konstant ansehen und aus den Daten schätzen. Quasi konstant ist die Beschleunigung in der vorgenannten Ausführung deswegen, weil auf Grund der Trägheit des Fahrzeugs zumindest zwischen zwei Achsen immer nur eine vernachlässigbare Änderung der Beschleunigung auftreten kann. Mit Hilfe der Geschwindigkeit kann man daher auch bei Vorliegen einer momentanen ("konstanten") Beschleunigung die Messwerte der betroffenen Achszähler wieder auf die Normalgeschwindigkeit (unter Annahme einer Beschleunigung von Null) zurückrechnen (das heißt normieren). Diese Normalgeschwindigkeit, die nun für den betreffenden Achsabstand angenommen wird, entspricht der für diesen geltenden Einzelgeschwindigkeit.

Gemäß einer Ausgestaltung der Erfindung ist vorgesehen, dass die Einzelgeschwindigkeit als Durchschnittsgeschwindigkeit berechnet wird, die das Fahrzeug in der Zeitspanne zwischen dem Passieren des Achszählers durch die den Achsabstand definierenden Achsen aufweist.

Die Durchschnittsgeschwindigkeit stellt vorteilhaft ein vergleichsweises einfach zu berechnetes Kriterium dar, welches die tatsächlichen Geschwindigkeiten von Achse zu Achse gut annähert. Diese lässt sich beispielsweise dadurch berechnen, dass die Zeit, die bei Passieren des Achszählers durch eine bestimmte Achse bis zur darauffolgenden Achse vergeht, erfasst wird und daraus bei bekanntem Abstand der Achsen (Kenntnis des zum Fahrzeug gehörenden Musters, Bestätigung eines Zuordnungsergebnisses) die Durchschnittsgeschwindigkeit berechnet wird. Die Durchschnittsgeschwindigkeit lässt sich auch dadurch berechnen, dass die Zeit, die durch das Passieren einer bestimmten Achse von einem Achszähler zum nächsten Achszähler vergeht, erfasst wird und daraus bei bekannten Abstand der Achszähler die Geschwindigkeit berechnet wird.

Gemäß einer Ausgestaltung der Erfindung ist vorgesehen, dass die Durchschnittsgeschwindigkeit aus den beiden durch den Achszähler anhand der den Achsabstand definierenden Achsen berechneten Geschwindigkeiten der Achsen berechnet wird.

Diese Ausgestaltung der Erfindung setzt voraus, dass mittels der eingesetzten Achszähler die augenblickliche Geschwindigkeit des überfahrenen Rades des Fahrzeugs gemessen werden kann. In diesem Fall steht für jede Achse ein Geschwindigkeitswert zur Verfügung. Wird ein Fahrzeug beschleunigt oder verlangsamt (was eine negative Beschleunigung bedeutet), verändert sich für jede Achse der gemessene Wert für die Geschwindigkeit. Für den betreffenden Achsabstand ergeben daher vorteilhaft der Mittelwert der Geschwindigkeiten der den Achsabstand definierenden Achsen einen guten Näherungswert für die Einzelgeschwindigkeit.

Gemäß einer Ausgestaltung der Erfindung ist vorgesehen, dass der Signalverlauf vor der Ermittlung der Achsabstände geglättet wird.

Die Maßnahme der Glättung berücksichtigt den Umstand, dass es schwierig sein kann, zwischen aufeinanderfolgenden Rädern den zeitlichen Abstand genau zu schätzen, wenn es ist nicht klar ist, wann ein Rad oder der Radmittelpunkt den Sensor erreicht hat, da die Rohdaten normalerweise mehr oder weniger gestört bzw. verrauscht sind. Daher wird die rohe Zeitreihe (Messwerte des Achszählers) mit einem Filter geglättet, z. B. mit einer Wavelet-Transformation oder in einfachen Fällen mit einem gleitenden Durchschnitt (moving average). Dadurch erhält man eine hinreichend glatte Zeitreihe und kann z. B. den Radmittelpunkt (als Maximum) oder sonstige Charakteristika des Rades (z. B. über Schwellwerte) schätzen. Diese Werte werden bei jedem Rad ermittelt und bilden dann die Grundlage für Zeitmessungen.

Gemäß einer Ausgestaltung der Erfindung ist vorgesehen, dass in einem weiteren Prüfungsschritt als eine weitere Eigenschaft des Fahrzeugs die Gesamtlänge des Fahrzeugs ermittelt wird. Gemäß einer weiteren Ausgestaltung der Erfindung ist vorgesehen, dass gemessene Geschwindigkeiten hinsichtlich Richtung und/oder Betrag und/oder die Gesamtlänge einer Plausibilitätsprüfung unterzogen werden und das Ergebnis der Plausibilitätsprüfung ausgegeben wird.

Aus den ermittelten Mustern der Fahrzeuge können Prüfbedingungen abgeleitet werden, mit denen das Signal plausibilisiert werden kann, z. B. sollte die Geschwindigkeit kleiner sein als die Streckenhöchstgeschwindigkeit (ggf. unter Berücksichtigung eines Toleranzbereiches). Oder die Geschwindigkeiten sollten alle dasselbe Vorzeichen haben (sonst wäre rückwärts gefahren worden, was unter realen Bedingungen zumindest auf freier Strecke normalerweise nicht vorkommt). Falls eine Plausibilitätsprüfung fehlschlägt, wird das Signal konservativ bewertet, z. B. die Zuggattung als unbekannt gesetzt.

Nach der Plausibilitätsprüfung werden alle statischen Regeln, die sich aus Fahrzeug- bzw. Streckenmodellen ergeben, angewendet. Z. B., wenn der längste Passagierzug 500 m lang ist, dann werden alle längeren Züge (ggf. unter Berücksichtigung eines Toleranzbereiches) automatisch als Güterzüge klassifiziert. Oder Züge mit einer Geschwindigkeit von mehr als 160km/h als Passagierzüge. Aber es können auch kompliziertere Regeln über die abgeleiteten Daten gebildet werden: z. B. werden Züge mit stark wechselnder Beschleunigung als unbekannt klassifiziert, denn entweder handelt es sich um einen außergewöhnlichen Betriebsfall oder um einen Angriff.

Als weiteres Beispiel mag das TBV (Tunnelbegegnungsverbot) vor einem Tunnel auf einer Neubaustrecke dienen. Dort wird in der Regel nicht rangiert und auch nicht rückwärtsgefahren, nicht mal nach einem SPAD (signal passed at danger unzulässige Signalvorbeifahrt). Die Streckenhöchstgeschwindigkeit für die Zuggattungen ist bekannt.

In dem Plausibilisierungsschritt werden deshalb aus dem Rohsignal der Zeitreihe wichtige physikalische Parameter ermittelt, wie z. B. bei jedem Rad die Geschwindigkeit v, bei aufeinanderfolgenden Rädern die Beschleunigung a, die Länge des Zuges usw.

Neben der Erfassung der Achszahl ist der Achszähler wegen der üblichen Ausführung als Doppelsensorsystem auch grundsätzlich geeignet, weitere Daten wie die oben genannten zu ermitteln. Außerdem ist es relativ einfach möglich, den Achszähler durch einfache Sensoren zu ergänzen, die z. B. die Achslast bei der Überfahrt.

Beispielhaft können folgende Messprinzipien verwendet werden.
- Fahrtrichtung des Zuges: durch Vergleich der Beeinflussung bei Doppelsensoren (z.B. durch Auswertung des Zeitversatzes bei der Signalgenerierung),
- Geschwindigkeit des Zuges bei Überfahrt einer Achse: aus dem Abstand der Doppelsensoren z. B. durch Auswertung des Zeitversatzes bei der Signalgenerierung oder dem zeitlichen Abstand des Passierens der geschätzten Radmittelpunkte bei bekannten Achsabständen,
- durchschnittliche Geschwindigkeit bei der Überfahrt und/oder die Beschleunigung bei der Überfahrt: aus der Mittelung über verschiedene Räder bzw. numerische Ableitung der Geschwindigkeit,
- Raddurchmesser: aus der zeitlichen Dauer einer Beeinflussung des Achszählers.

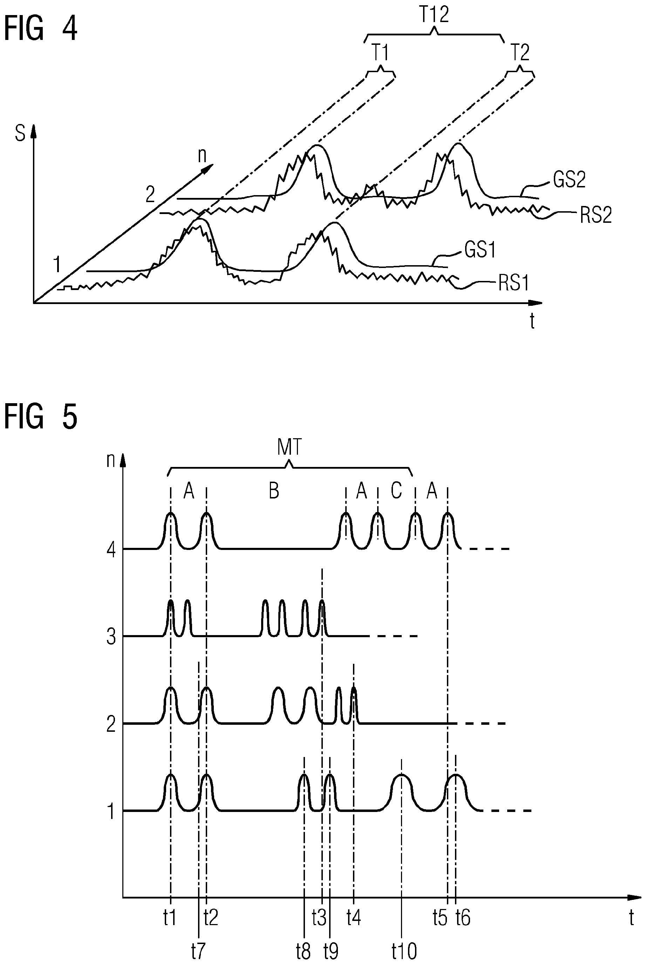

Aus einem so ermittelten Parametersatz wird vorteilhat ein für den Anwendungsfall geeigneter Parametersatz ausgewählt. Z. B. kann man den Raddurchmesser weglassen, wenn er für alle Züge auf der Strecke mehr oder weniger gleich ist. Für die in Frage kommenden Parameter werden jetzt ortsspezifische, repräsentative Daten erhoben bzw. gemessen und klassifiziert, z. B. Personenzug, Güterzug. Es handelt sich um eine endliche Zahl von ganzzahligen oder reell wertigen Messwerten, z. B. könnten dies die Geschwindigkeit und die Achszahl sein, um hier ein anschauliches zweidimensionales Beispiel zu geben. D. h. prinzipiell erhält man eine Klassifikationsaufgabe, wie im Folgenden zu Figur 5 beschrieben.

Insgesamt macht die Erhebung von weiteren Parametern als zusätzliche Eigenschaften zusätzlich zu den zu vergleichenden Mustern die Erkennung von Eigenschaften von Fahrzeugen robuster gegenüber Fehlern. Vorteilhaft kann bei der Zugerkennung ein höherer Grad für die Zuverlässigkeit erreicht werden, so dass der Zugverkehr effektiver gesteuert werden kann. Welche Parameter bei einer vorliegenden Steuerungsaufgabe für den Zugverkehr zu berücksichtigen sind, hängt dann von den Gegebenheiten des Einzelfalles ab. Sie sind bei der Konzipierung des Steuerungsverfahrens in geeigneter Weise auszuwählen.

Gemäß einer Ausgestaltung der Erfindung ist vorgesehen, dass für den ersten Prüfungsschritt und/oder den weiteren Prüfungsschritt ein Verfahren des maschinellen Lernens ausgewertet werden.

Das maschinelle Lernen ermöglicht vorteilhaft eine Optimierung der ablaufenden Prozesse, d. h. der zuverlässigen Erkennung der Zugeigenschaften, insbesondere Zuggattungen, während des Betriebs. Hierdurch kann sich das System auch automatisch an sich verändernde Betriebsbedingungen anpassen. Beispielsweise können zusätzliche Muster erstellt werden, wenn auf einem bestimmten Streckenabschnitt ein neuer Typ von Personenzügen eingesetzt wird. Anwendbar sind zu diesem Zweck z. B. neuronale Netze oder auch andere Einrichtungen mit künstlicher Intelligenz.

Unter künstlicher Intelligenz (im Folgenden auch mit KI abgekürzt) ist im Rahmen dieser Erfindung im engeren Sinne das rechnergestützte maschinelle Lernen (Machine Learning, im Folgenden auch mit ML abgekürzt) zu verstehen. Es geht dabei um das statistische Lernen der Parametrisierung von Algorithmen, vorzugsweise für komplexe Anwendungsfälle. Mittels ML erkennt und erlernt das System anhand von zuvor eingegebenen Lerndaten Muster und Gesetzmäßigkeiten bei den erfassten Prozessdaten. Mithilfe geeigneter Algorithmen können durch ML eigenständig Lösungen zu aufkommenden Problemstellungen gefunden werden. ML gliedert sich in drei Felder - überwachtes Lernen, unüberwachtes Lernen und bestärkendes Lernen (Reinforcement Learning), mit spezifischeren Anwendungen, zum Beispiel Regression und Klassifikation, Strukturerkennung und -vorhersage, Datengenerierung (Sampling) oder autonomes Handeln.

Beim überwachten Lernen wird das System durch den Zusammenhang von Eingabe und zugehöriger Ausgabe bekannter Daten trainiert und erlernt auf diese Weise approximativ funktionale Zusammenhänge. Dabei kommt es auf die Verfügbarkeit geeigneter und ausreichender Daten an, denn wenn das System mit ungeeigneten (z.B. nicht-repräsentativen) Daten trainiert wird, so lernt es fehlerhafte funktionale Zusammenhänge. Beim unüberwachten Lernen wird das System ebenfalls mit Beispieldaten trainiert, jedoch nur mit Eingabedaten und ohne Zusammenhang zu einer bekannten Ausgabe. Es lernt, wie Datengruppen zu bilden und zu erweitern sind, was typisch für den Anwendungsfall ist und wo Abweichungen bzw. Anomalien auftreten. Dadurch lassen sich Anwendungsfälle beschreiben und Fehlerzustände entdecken. Beim bestärkenden Lernen lernt das System durch Versuch und Irrtum, indem es zu gegebenen Problemstellungen Lösungen vorschlägt und über eine Feedbackfunktion eine positive oder negative Bewertung zu diesem Vorschlag erhält. Je nach Belohnungsmechanismus erlernt das KI-System, entsprechende Funktionen auszuführen.

Das maschinelle Lernen kann beispielsweise durch künstliche neuronale Netze (im Folgenden für artificial neural network, kurz ANN genannt) durchgeführt werden. Künstliche neuronale Netze basieren meist auf der Vernetzung vieler Neuronen, beispielsweise McCulloch-Pitts-Neuronen oder leichter Abwandlungen davon. Grundsätzlich können auch andere künstliche Neuronen Anwendung in ANN finden, z. B. das High-Order-Neuron. Die Topologie eines Netzes (die Zuordnung von Verbindungen zu Knoten) muss abhängig von seiner Aufgabe bestimmt werden. Nach der Konstruktion eines Netzes folgt die Trainingsphase, in der das Netz "lernt". Dabei kann ein Netz beispielsweise durch folgende Methoden lernen:
- Entwicklung neuer Verbindungen
- Löschen existierender Verbindungen
- Ändern der Gewichtung (der Gewichte von Neuron j zu Neuron i)
- Anpassen der Schwellenwerte der Neuronen, sofern diese Schwellwerte besitzen
- Hinzufügen oder Löschen von Neuronen
- Modifikation von Aktivierungs-, Propagierungs- oder Ausgabefunktion

Außerdem verändert sich das Lernverhalten bei Veränderung der Aktivierungsfunktion der Neuronen oder der Lernrate des Netzes. Praktisch gesehen lernt ein ANN hauptsächlich durch Modifikation der Gewichte der Neuronen. Eine Anpassung des Schwellwertes kann hierbei durch ein on-Neuron miterledigt werden. Dadurch sind ANN in der Lage, komplizierte nichtlineare Funktionen über einen Lernalgorithmus, der durch iterative oder rekursive Vorgehensweise aus vorhandenen Ein- und gewünschten Ausgangswerten alle Parameter der Funktion zu bestimmen versucht, zu erlernen. ANN sind dabei eine Realisierung des konnektionistischen Paradigmas, da die Funktion aus vielen einfachen gleichartigen Teilen besteht. Erst in ihrer Summe wird das Verhalten komplex.

Gemäß einer Ausgestaltung der Erfindung ist vorgesehen, dass das Verfahren maschinellen Lernens nur dann angewendet wird, wenn das Ergebnis der Plausibilitätsprüfung positiv ist.

Ein zusätzlicher Vorteil besteht, wie bereits erläutert, darin, die KI-Mustererkennung durch strecken- und fahrzeugspezifische Prüf- und Plausibilitätsbedingungen zu unterstützen. Wichtig ist dabei, bei der Plausibilitätsprüfung mathematische Invarianten der in dem Signal enthaltenen Informationen auszunutzen. Der wesentliche Vorteil liegt darin, dass man dadurch die Dimensionalität und Komplexität des zu bewertenden Problems drastisch reduziert und viel weniger Daten für Training und Validierung des KI-Algorithmus durch maschinelles Lernen benötigt.

Außerdem erschwert man sog. Adversarial Attacks. Unter einer Adversarial Attack (zu deutsch "feindlicher Angriff") versteht man im Kontext von Künstlicher Intelligenz (KI) bzw. maschinellem Lernen die Verwendung von Adversarial Examples (zu Deutsch "feindliche Beispiele") zur Manipulation der Klassifikationsergebnisse. Ein Adversarial Example ist ein speziell manipuliertes Eingangs-Signal in ein künstliches Neuronales Netzwerk, welches dieses absichtlich zu Fehlklassifikationen verleitet. Die Manipulation wird so vorgenommen, dass ein menschlicher Beobachter diese nicht bemerkt oder nicht als solche erkennt. Beispielsweise bei einem zur Objekterkennung trainierten neuronalen Netzwerk könnten die Pixel eines Bildes leicht verändert werden, sodass diese Veränderungen für Menschen nicht sichtbar sind, das Netzwerk die Objekte auf dem Bild jedoch falsch zuordnet. In allen Anwendungsbereichen neuronaler Netzwerke konnte die Anfälligkeit für Adversarial Examples gezeigt werden. Aufgrund der zunehmenden Erfolge tiefer neuronaler Netzwerke und deren Einsatz in sicherheitskritischen Aufgaben, wie im autonomen Fahren, rücken Adversarial Attacks und Methoden zur Abwehr oder Erkennung solcher Adversarial Examples zunehmend in den Fokus.

Gemäß einer Ausgestaltung der Erfindung ist vorgesehen, dass aus den Messdaten einer Vielzahl von Messungen Wahrscheinlichkeitsdichten für die Eigenschaften ermittelt werden.

Die Kenntnis der Wahrscheinlichkeitsdichten ermöglicht es, Klassifikationsgrenzen für die Zuordnung der Eigenschaften zu definieren. Dabei ist das Verfahren vorteilhaft hinsichtlich der Klassifikationsgrenzen sehr robust, denn bei den erfindungsgemäßen, vergleichsweise niedrigdimensionalen Problemen kann man aus den Daten die Wahrscheinlichkeitsdichten für die verschiedenen Klassen schätzen (z. B. mit Dichteschätzung der Messergebnisse) und damit auch die Fehlerwahrscheinlichkeiten für eine inkorrekte Klassifikation ermitteln.

Die genannte Aufgabe wird alternativ mit dem eingangs angegebenen Anspruchsgegenstand (Vorrichtung) erfindungsgemäß auch dadurch gelöst, dass der eingesetzte Computer außerdem dazu eingerichtet ist, bei der Ermittlung der Eigenschaft ein Verfahren nach einem der vorstehenden Ansprüche durchzuführen.

Mit der Vorrichtung lassen sich die Vorteile erreichen, die im Zusammenhang mit dem obenstehend näher beschriebenen Verfahren bereits erläutert wurden. Das zum erfindungsgemäßen Verfahren Aufgeführte gilt entsprechend auch für die erfindungsgemäße Vorrichtung.

Des Weiteren wird ein Computerprogrammprodukt mit Programmbefehlen zur Durchführung des genannten erfindungsgemäßen Verfahrens und/oder dessen Ausführungsbeispielen beansprucht, wobei mittels des Computerprogrammprodukts jeweils das erfindungsgemäße Verfahren und/oder dessen Ausführungsbeispiele durchführbar sind.

Darüber hinaus wird eine Bereitstellungsvorrichtung zum Speichern und/oder Bereitstellen des Computerprogrammprodukts beansprucht. Die Bereitstellungsvorrichtung ist beispielsweise ein Speichereinheit, die das Computerprogrammprodukt speichert und/oder bereitstellt. Alternativ und/oder zusätzlich ist die Bereitstellungsvorrichtung beispielsweise ein Netzwerkdienst, ein Computersystem, ein Serversystem, insbesondere ein verteiltes, beispielsweise cloudbasiertes Computersystem und/oder virtuelles Rechnersystem, welches das Computerprogrammprodukt vorzugsweise in Form eines Datenstroms speichert und/oder bereitstellt.

Die Bereitstellung erfolgt in Form eines Programmdatenblocks als Datei, insbesondere als Downloaddatei, oder als Datenstrom, insbesondere als Downloaddatenstrom, des Computerprogrammprodukts. Diese Bereitstellung kann beispielsweise aber auch als partieller Download erfolgen, der aus mehreren Teilen besteht. Ein solches Computerprogrammprodukt wird beispielsweise unter Verwendung der Bereitstellungsvorrichtung in ein System eingelesen, sodass das erfindungsgemäße Verfahren auf einem Computer zur Ausführung gebracht wird.

Weitere Einzelheiten der Erfindung werden nachfolgend anhand der Zeichnung beschrieben. Gleiche oder sich entsprechende Zeichnungselemente sind jeweils mit den gleichen Bezugszeichen versehen und werden nur insoweit mehrfach erläutert, wie sich Unterschiede zwischen den einzelnen Figuren ergeben.

Bei den im Folgenden erläuterten Ausführungsbeispielen handelt es sich um bevorzugte Ausführungsformen der Erfindung. Die Erfindung wird durch die beigefügten Ansprüche definiert.

Es zeigen:
Figur 1 ein Ausführungsbeispiel der erfindungsbemäßen Vorrichtung mit ihren Wirkzusammenhängen schematisch und mit einer Computer-Infrastruktur (Rechenumgebung) der Vorrichtung als Blockschaltbild, wobei die einzelnen Funktionseinheiten Programmmodule enthalten, die jeweils in einem oder mehreren Prozessoren ablaufen können und die Schnittstellen demgemäß softwaretechnisch oder hardwaretechnisch ausgeführt sein können,
Figur 2 und 3 schematisch teils identische bzw. ähnliche Muster von Achsabständen für einen Personenzug und einen Güterzug,
Figur 4 ein Diagramm der Signalstärke s in Abhängigkeit von der Zeit t eines Doppelachszählers mit zwei Sensoren n gleich 1 und 2 für ein Ausführungsbeispiel des erfindungsgemäßen Verfahrens,
Figur 5 verschiedene Signalverläufe n eines Achszählers in Abhängigkeit von der Zeit t als Diagramm für ein Ausführungsbeispiel des erfindungsgemäßen Verfahrens,
Figur 6 ein Ausführungsbeispiel des erfindungsgemäßen Verfahrens als Flussdiagramm, wobei die Funktionseinheiten und Schnittstellen gemäß Figur 1 beispielhaft angedeutet sind und wobei die einzelnen Verfahrensschritte einzeln oder in Gruppen durch Programmmodule verwirklicht sein können und wobei die Funktionseinheiten und Schnittstellen gemäß Figur 2 beispielhaft angedeutet sind,
Figur 7 symbolhaft für zwei Normalverteilungen für ermittelte Messdaten zur Erläuterung des Prinzips.

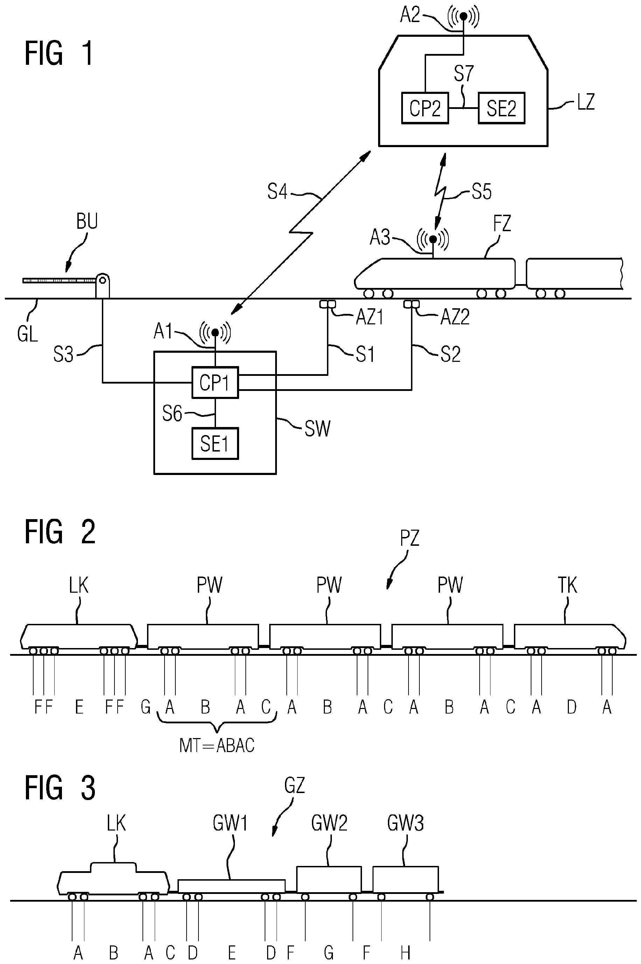

In Figur 1 ist eine Gleisanlage mit einem Gleis GL, einer Leitzentrale LZ, die einen zweiten Computer CP2 und eine über eine siebente Schnittstelle S7 mit diesem verbundene zweite Speichereinrichtung SE2 aufweist, und ein Stellwerk SW dargestellt. Auf dem Gleis GL fährt ein Fahrzeug FZ in Form eines Zuges auf einen Bahnübergang BU zu. Am Gleis GL sind ein erster Achszähler AZ1 und ein zweiter Achszähler AZ2 installiert, die in an sich bekannter Weise dazu eingerichtet sind, die Achsen des Fahrzeugs FZ zu zählen.

Der Achszähler AZ1 ist über eine erste Schnittstelle S1 sowie der zweite Achszähler AZ2 über eine zweite Schnittstelle S2 mit dem Stellwerk SW, genau genommen mit einem in diesem Stellwerk vorhandenen ersten Computer CP1, verbunden. Außerdem weist der erste Computer CP1 eine dritte Schnittstelle S3 für den Bahnübergang BU auf. Außerdem ist der erste Computer CP1 über eine sechste Schnittstelle S6 mit einer Speichereinheit SE1 verbunden.

Das Stellwerk SW weist eine erste Antennenanlage A1, die Leitzentrale LZ eine zweite Antennenanlage A2 und das Fahrzeug FZ eine dritte Antennenanlage A3 auf. Hierdurch ist sowohl die Kommunikation des Stellwerks SW über eine vierte Schnittstelle S4 mit der Leitzentrale LZ als auch die Kommunikation des Fahrzeugs FZ über eine fünfte Schnittstelle S5 mit der Leitzentrale LZ möglich. Bei der vierten Schnittstelle S4 und der fünften Schnittstelle S5 handelt es sich insofern um Funkschnittstellen. Die erste Schnittstelle S1, die zweite Schnittstelle S2 sowie die dritte Schnittstelle S3 können sowohl leitungsgebunden als auch Funkschnittstellen darstellen, wobei für den letzten Fall die Antennentechnik, die zur Ausbildung von Funkschnittstellen erforderlich wäre, nicht dargestellt ist.

Bewegt sich das Fahrzeug FZ auf dem Gleis GL auf den Bahnübergang BU zu, passieren die Achsen des Fahrzeugs FZ zunächst den zweiten Achszähler AZ2 und anschließend den ersten Achszähler AZ1. Die aufgenommenen Messwerte können über die erste Schnittstelle S1 und die zweite Schnittstelle S2 an den ersten Computer CP1 übertragen werden, wobei der erste Computer CP1 (und auch der zweite Computer CP2) zur Durchführung des erfindungsgemäßen Verfahrens eingerichtet ist. Dabei kann der erste Computer CP1 auch die Ansteuerung des Bahnübergangs BU direkt übernehmen. Eine andere Möglichkeit besteht darin, dass der erste Computer CP1 über die dritte Schnittstelle S3 mit einem weiteren Computer (in Figur 1 nicht dargestellt) verbunden ist, der über eine weitere Schnittstelle zur Ansteuerung des Bahnübergangs BU verwendet wird.

In Figur 2 ist ein auf dem Gleis GL als Fahrzeug FZ gemäß Figur 1 fahrender Personenzug PZ dargestellt. Dieser Personenzug PZ besteht aus einer Lokomotive LK, mehreren Personenwagen PW und einem Triebkopf TK an dem der Lokomotive LK gegenüberliegenden Ende des Personenzuges PZ.

Weiterhin sind schematisch die Achsabstände zwischen den einzelnen Achsen (angedeutet durch Räder) dargestellt. Es zeigt sich, dass in dem Personenzug PZ verschiedene Achsabstände mehrfach vorkommen, sodass die Folge der Achsabstände auf das Vorliegen von Mustern hin untersucht werden kann. Die Achsabstände sind mit den Großbuchstaben A bis G gekennzeichnet. Die Folge der Achsabstände besteht aus FFEFFGABACABACABACADA.

Lässt man die Lokomotive LK und den Triebkopf TK außer Acht, da diese sich hinsichtlich ihrer Achsabstände von den Personenwagen PW unterscheiden, so ergibt sich für die aufeinanderfolgenden Personenwagen, die baugleich sind, eine Folge von Achsabständen, die sich immer wiederholt. Diese bilden insofern ein Muster MT, welches für den auf die Lokomotive LK folgenden Personenwagen PW mit einer geschweiften Klammer gekennzeichnet ist. Die Abfolge der Achsabstände in dem in Figur 2 dargestellten Muster MT ist ABAC. Diese Folge von Achsabständen ergibt sich auch für die beiden nachfolgenden Personenwagen.

Anders verhält es sich in dem in Figur 3 dargestellten Güterzug GZ auf dem Gleis GL, der aus einer Lokomotive LK sowie einem ersten Güterwagen GW1, einem zweiten Güterwagen GW2 und einem dritten Güterwagen GW3 besteht. Diese weisen unterschiedliche Längen und Achszahlen auf, sodass sich mehrere unterschiedliche Achsabstände ergeben, die mit den Großbuchstaben A bis H versehen sind. In Figur 3 wird deutlich, dass sich in der dargestellten Folge ABACDEDFGFH keinerlei wiederholende Muster entdecken lassen, was den Rückschluss auf einen Güterzug erlaubt.

In Figur 4 ist der Signalverlauf s eines Doppelachszählers in Abhängigkeit von der Zeit t dargestellt. In diesem sind zwei Einzelsensoren verbaut, sodass es zwei Signalverläufe n gibt, die in Figur 4 mit 1 und 2 gekennzeichnet sind.

Zu erkennen ist in Figur 4, dass die beiden Einzelsensoren ein erstes Rohsignal RS1 und ein zweites Rohsignal RS2 erzeugen, welches durch einen Glättungsschritt des Verfahrens in ein erstes geglättetes Signal GS1 und ein zweites geglättetes Signal GS2 überführt wird. Diese stehen nun für eine weitere Auswertung zur Verfügung.

Die Einzelsensoren 1 und 2 sind in dem Doppelachszähler hintereinander verbaut, sodass sich beim Passieren eines Rades ein Zeitversatz bei der Erzeugung der Sensorsignale ergibt. Dieser Zeitversatz ist in der ersten Zeitspanne T1 und in der zweiten Zeitspanne T2 in Figur 4 dargestellt. Diese Zeitspanne kann beispielsweise dazu genutzt werden, um die Geschwindigkeit des den Sensor passierenden Rades und damit des Fahrzeugs zu berechnen.

Die erste Zeitspanne T1 ist einem ersten Rad und die zweite Zeitspanne T2 einem zweiten Rad zuzuordnen, wobei diese Räder beispielsweise einem Drehgestell eines Fahrzeugs angehören können. Bei bekannter Geschwindigkeit (berechnet durch die erste Zeitspanne T1 und/oder die zweite Zeitspanne T2) kann aus der sich ergebenden Zeitspanne T12, die zwischen der Detektion des ersten Rades und der Detektion des zweiten Rades liegt, der Abstand A der Achsen des Drehgestells (vgl. Figuren 2 und 5) berechnet werden.

In Figur 5 sind die Signalverläufe n = 1... 4 jeweils nur eines Sensors eines Doppelachszählers anhand des Musters MT gemäß Figur 2 dargestellt. Die verschiedenen Beispiele 1 bis 4 repräsentieren dabei unterschiedliche Geschwindigkeits- und Beschleunigungszustände des Fahrzeugs, welches den Achszähler überquert. Das erste eine Achse anzeigende Signal (wie auch in Figur 4 durch einen Signalanstieg und anschließenden Signalabfall dargestellt) liegt in allen Fällen 1 bis 4 im Zeitpunkt t1. Die unterschiedlichen Charakteristiken der Signalverläufe 1 bis 4 werden anhand der weiteren Zeitpunkte, die in Figur 5 dargestellt sind, erläutert.

Bei dem Signalverlauf 4 handelt es sich um einen Signalverlauf, bei dem durch Berechnung die Normalachsabstände A, B und C berechnet werden, da sich das Fahrzeug in diesem Fall mit der vorgegebenen Normalgeschwindigkeit bewegt. Mit anderen Worten wäre es nicht erforderlich, diesen Signalverlauf unter Berücksichtigung der vorgegebenen Normalgeschwindigkeit umzuformen, da sich dieser direkt mit den Referenzmustern vergleichen ließe.

Der Signalverlauf 3 ergibt sich, wenn das Fahrzeug mit einer konstanten Geschwindigkeit den Achszähler überquert, wobei diese Geschwindigkeit höher ist als die Normalgeschwindigkeit. Dies lässt sich in Figur 5 daran erkennen, dass der Signalverlauf 3 im Vergleich zum Signalverlauf 4 auf der Zeitachse gestaucht ist. Während der Signalverlauf 4 vom Zeitpunkt T1 bis zum Zeitpunkt T6 reicht, endet der Signalverlauf 3 früher im Zeitpunkt T3.

Der Signalverlauf 2 ergibt sich, wenn das Fahrzeug während der Überfahrt des Achszählers konstant beschleunigt wird. Hier ist zu erkennen, dass der Signalverlauf 2 nicht wie der Signalverlauf 3 mit einem konstanten Faktor gestaucht ist, sondern dass die Stauchung des Signals kontinuierlich zunimmt. Daher ist bereits die zweite Spitze des Signalverlaufs zum Zeitpunkt T7 im Vergleich zum Zeitpunkt T2 in der zweiten Spitze des Signalverlaufs 4 leicht verschoben. Es wird davon ausgegangen, dass das Fahrzeug im Zeitpunkt T1 dieselbe Geschwindigkeit hatte wie das Fahrzeug bei dem Signalverlauf 4, also die Normalgeschwindigkeit. Deshalb liegt der Zeitpunkt T7 früher als der Zeitpunkt T2. Der Signalverlauf endet damit insgesamt zum Zeitpunkt T4 früher als der Signalverlauf 4, der im Zeitpunkt T6 endet.

Der Signalverlauf 1 zeigt ein nicht konstantes Beschleunigungsverhalten des Fahrzeugs bei der Überquerung des Achszählers. Anhand der Zeitpunkte T1 und T2 lässt sich erkennen, dass das Fahrzeug zu diesem Zeitpunkt mit der Normalgeschwindigkeit unterwegs ist. Die Zeitpunkte T8 und T9 zeigen, dass hier eine größere Geschwindigkeit vorliegt, sodass eine Beschleunigung stattgefunden hat (t8 und T9 liegen enger beieinander als T1 und T2) . Außerdem zeigen T10 und T6, dass hier eine geringere Geschwindigkeit vorliegt als zum Zeitpunkt T1 und T2 (T10 und T6 haben einen größeren Abstand als T1 und T2) . Hierbei ist zu bemerken, dass die Signale lediglich repräsentativ sind und zwischen den Zeitpunkten T2 und T8 sowie T1 und T10 weitere Achsen liegen könnten, die weitere nicht dargestellte Spitzen erzeugen würden.

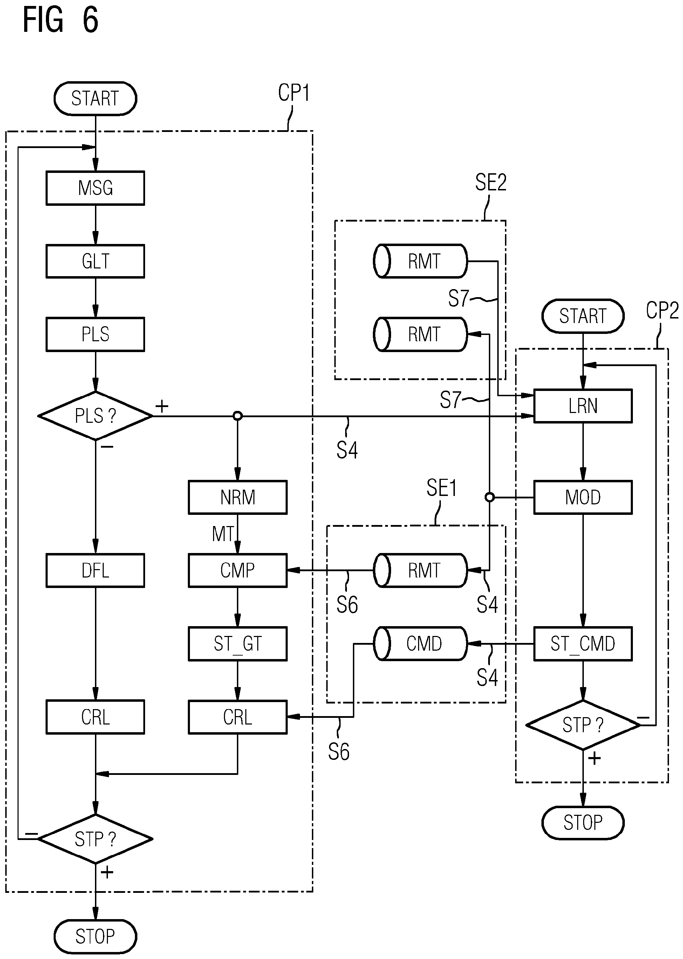

Nach dem zu Figur 4 beschriebenen Verfahren lässt sich für alle in Figur 5 dargestellten Signalverläufe jeweils unter Berücksichtigung benachbarter Spitzen ein Achsabstand berechnen. Unter Berücksichtigung der gemessenen Geschwindigkeiten und daraus berechneten Einzelgeschwindigkeiten (beispielsweise als Einzelgeschwindigkeiten berechnete Durchschnittsgeschwindigkeiten bezüglich jeweils benachbarter Achsen) lässt sich dieser jeweils normieren, sodass unabhängig von dem Geschwindigkeits- bzw. Beschleunigungsverhalten des Fahrzeugs die Normalabstände A, B und C berechnet werden können. Das hierbei verwendete Verfahren ist zu Figur 6 beschrieben.

In Figur 6 ist das erfindungsgemäße Verfahren dargestellt, wobei dieses beispielhaft verteilt durch den ersten Computer CP1 und den zweiten Computer CP2 durchgeführt wird. Es kommen dabei die erste Speichereinrichtung SE1 und die zweite Speichereinrichtung SE2 zum Einsatz. Das Verfahren startet sowohl im Computer CP1 als auch im Computer CP2. Im Computer CP2 wird ein Messschritt MSG durchgeführt, der Signalverläufe gemäß Figur 4 und 5 beispielhaft erzeugen kann. Anschließend folgt ein Glättungsschritt GLT zur Erzeugung eines geglätteten Signals GS1, GS2 aus den jeweiligen Rohsignalen RS1, RS2 (vgl. Figur 4). Anschließend wird ein Plausibilisierungsschritt durchgeführt, bei dem bestimmte Eigenschaften des Signalverlaufs herangezogen werden können, um vorab eine Beurteilung durchführen zu können, ob der Signalverlauf einen realistischen Betriebszustand des Fahrzeugs repräsentiert. Hierdurch können z. B. Messfehler erkannt werden, aber auch feindliche Attacken auf die Vorrichtung, wobei beides zu ungewollten Betriebszuständen bis hin zu Unfällen führen könnte.

In einem Abfrageschritt PLS? wird überprüft, ob die Plausibilisierung erfolgreich durchgeführt werden konnte oder nicht. Ist dies nicht der Fall, so wird ein Standardschritt DFL durchgeführt, der das System sicher betreiben kann oder in einen sicheren Zustand überführt. Ein sicheres Betreiben ist z. B. in einem Fall eines Bahnübergangs möglich, wenn für die Schließzeit des Bahnübergangs der ungünstigste Fall eines schnell herannahenden Personenzuges angenommen wird und die Schranken früh ausgelöst werden. Ein Zwischenfall kann damit selbst für den ungünstigsten anzunehmenden Fall ausgeschlossen werden. Ein Beispiel für eine Sicherungsmaßnahme ist das Einleiten einer Notbremsung für das Fahrzeug.

Konnte die Plausibilisierung erfolgreich durchgeführt werden, so wird das mit der Messung erzeugte Muster MT im ersten Computer CP1 ein Normierungsschritt NRM durchgeführt. Dieser verläuft nach den in Figur 5 erläuterten Prinzipien, sodass als Ergebnis das Muster MT mit Normalachsabständen erzeugt wird. Dieses kann in einem Vergleichsschritt CMP mit Referenzmustern RMT verglichen werden, die in der ersten Speichereinrichtung SE1 abgespeichert sind und von dort abgerufen werden.

Wurde ein Referenzmuster RMT erkannt, so kann in einem Auswahlschritt für die Gattung des Fahrzeugs ST_GT beispielsweise eine Zuggattung wie Personenzug, Nahverkehrszug oder Güterzug ausgewählt werden. Anschließend kann in einem Steuerungsschritt CRL eine auf die erkannte Zuggattung zugeschnittene Steuerung, beispielsweise einer Bahnkomponente, durchgeführt werden. Z. B. kann die Schließzeit eines Bahnübergangs in Abhängigkeit von der erkannten Zuggattung gesteuert werden. Zum Zweck der Modifikation des Steuerungsschritts CRL können Steuerbefehle CMD aus der ersten Speichereinrichtung SE1 abgerufen werden.

Außerdem wird das plausibilisierte Ergebnis an den zweiten Computer CP2 übertragen. In diesem wird ein maschineller Lernschritt LRN durchgeführt, wobei der zweite Computer CP2 mit einer künstlichen Intelligenz, beispielsweise durch Anwendung eines neuronalen Netzwerks, ausgestattet ist. Wurde der maschinelle Lernschritt erfolgreich durchgeführt, folgt ein Modifizierungsschritt MOD, welcher modifizierte oder neue Referenzmuster RMT erzeugt. Beispielsweise könnte erkannt werden, dass auf einer bestimmten Strecke, auf der der Achszähler verbaut ist, neue Hochgeschwindigkeitszüge mit einer größeren Wagenzahl fahren. Ein entsprechendes Referenzmuster RMT wird dann entsprechend in der zweiten Speichereinrichtung SE2 abgelegt.

Außerdem können aufgrund der gelernten Modifikationen in einem Erstellungsschritt für Steuerbefehle ST_CMD für betreffende Referenzmuster RMT geeignete neue Steuerbefehle CMD erzeugt werden. Diese werden in der ersten Speichereinrichtung SE1 abgespeichert.

Für die Verfahren im ersten Computer CP1 und im zweiten Computer CP2 erfolgt eine Abfrage STP?, ob das Betriebsende bzw. das Prozessende erreicht ist. Ist dies der Fall, wird das Verfahren gestoppt. Ist dies nicht der Fall, so beginnen die Prozesse im ersten Computer CP1 mit einem erneuten Messschritt MSG und nach Bedarf der Prozess im zweiten Computer CP2 mit einem erneuten Lernschritt LRN.

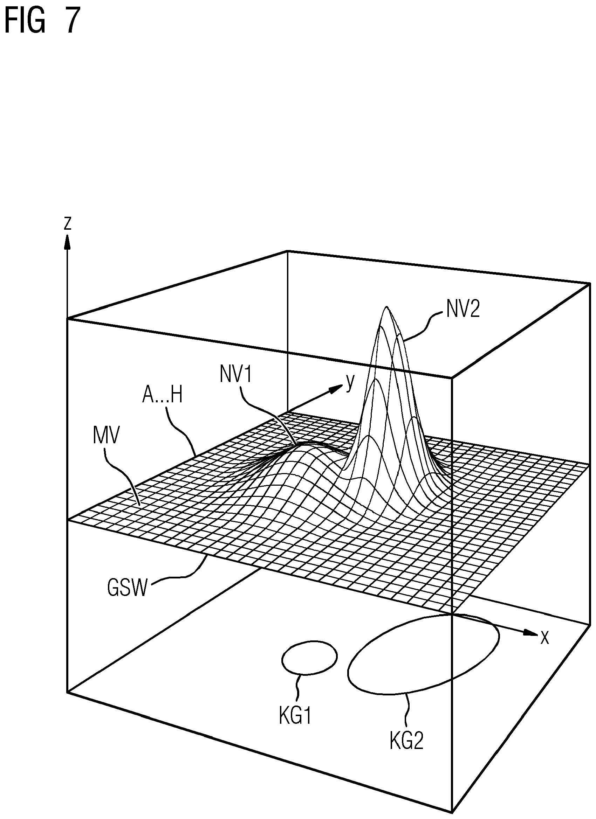

In Figur 7 sind exemplarisch zwei durch die Achszähler erfindungsgemäß gemessene bzw. bestimmbare Parameter in einer Ebene dargestellt die auch als x-y-Ebene bezeichnet werden könnte und auf der die Messwertverteilung MV der Messwerte deutlich wird. Demnach wäre auf der x-Achse die Geschwindigkeit GSW und auf der Y-Achse Achsabstände A ... H dargestellt. Die z-Achse dient der Darstellung der (beispielsweise geschätzten) Wahrscheinlichkeitsdichten

Für die in Frage kommenden Parameter werden in diesem Beispiel ortsspezifische, repräsentative Daten erhoben bzw. gemessen und klassifiziert, z. B. Personenzug als Normalverteilung NV2 und Güterzug als Normalverteilung NV1, wie oben bereits beschrieben. Es handelt sich um eine endliche Zahl von ganzzahligen oder reell wertigen Messdaten der Achszähler, z. B. könnten dies die Geschwindigkeit und der Achsabstand sein, um hier ein anschauliches zweidimensionales Beispiel zu geben. D. h., prinzipiell erhält man eine Klassifikationsaufgabe, wie in Figur 7 schematisch dargestellt.

Bei Vorliegen repräsentativer Daten ist bekannt, wie man solche Probleme der Mustererkennung mit Verfahren des Machine Learning z. B. durch neuronale Netzwerke löst. Dabei ist bei dieser Anwendung bei Achszählern ein großer Spielraum gegeben, wie man die Klassifikationsgrenze setzt, denn bei solchen niedrigdimensionalen Problemen kann man aus den Daten die Wahrscheinlichkeitsdichten für die beiden Klassen auch schätzen (z. B. mit Dichteschätzung) . Damit kann man die Fehlerwahrscheinlichkeiten für eine inkorrekte Klassifikation ermitteln (vgl. z. B. Duda et al.: Pattern Classification, Wiley, 2001), Figur 5 zeigt dies symbolhaft für eine erste Normalverteilungen NV1 und eine zweite Normalverteilung NV2, aber im Prinzip funktioniert dies auch für andere Verteilungen als Normalverteilungen.

Nimmt man im Beispiel an, die kleine Ellipse wäre die erste Klassifikationsgrenze KG1 für Güterzüge und die große Ellipse die Klassifizierungsgrenze KG2 für Personenzüge, dann könnte man mit den geschätzten Verteilungen die Fehlerwahrscheinlichkeiten berechnen. Falls die Fehlklassifikationswahrscheinlichkeit für Güterzüge zu hoch wäre, würde man die Klassifikationsgrenzen ändern. In dem Beispiel gemäß Figur 7 erhielte man dann eine kleinere Ellipse für die erste Klassifikationsgrenze KG1. Es kann aber auch Anwendungen geben, wo die Klassifikationsfehler asymmetrisch sind d.h. die Fehler nicht dieselbe Bedeutung haben. Z. B. wäre es bei der zeitgesteuerten Einschaltung eines Bahnübergangs unter Berücksichtigung der Sicherheit irrelevant, wenn ein langsamer Güterzug als schneller Personenzug klassifiziert würde, während dies beim Tunnelbegegnungsverbot gefährlich wäre. D. h. in jedem Fall muss der Sicherheitsaspekt bei der Auswertung der Fehlerarten bzw. -wahrscheinlichkeiten berücksichtigt werden.

### Bezugszeichenliste

- GL: Gleis
- FZ: spurgeführtes Fahrzeug (Schienenfahrzeug)
- BU: Bahnübergang
- LZ: Leitzentrale
- SW: Stellwerk
- A1 ... A3: Antenne
- AZ1 ... AZ2: Achszähler
- S1 ... S7: Schnittstelle
- CP1 ... CP2: Computer
- SE1 ... SE2: Speichereinheit

- PZ: Personenzug
- LK: Lokomotive
- PW: Personenwagen
- TK: Triebkopf
- GZ: Güterzug
- GW1 ... GW3: Güterwagen
- A ... H: Achsabstand
- MT: Muster
- RMT: Referenzmuster

- MSG: Messschritt
- GLT: Glättungsschritt
- PLS: Plausibilisierungsschritt
- PLS?: Abfrageschritt erfolgte Plausibilisierung
- DFL: Standardschritt
- CRL: Steuerungsschritt
- NRM: Normierungsschritt
- CMP: Vergleichsschritt
- ST_GT: Auswahlschritt für Gattung
- CMD: Steuerbefehle
- LRN: maschineller Lernschritt
- MOD: Modifizierungsschritt
- ST_CMD: Erstellungsschritt für Steuerbefehle
- STP?: Abfrageschritt für Prozessende

- S: Messsignal
- t: Zeit
- t1 ... t10: Zeitpunkte
- T1 ... T12: Zeitspannen
- RS1 ... RS2: Rohsignal
- GS1 ... GS2: geglättetes Signal

## Patentansprüche

1. Verfahren zum Erkennen von Eigenschaften eines spurgeführten Fahrzeugs (FZ), bei dem
• ein Achszähler (AZ1 ... AZ2) während der Überfahrt des spurgeführten Fahrzeugs (FZ) Messdaten erfasst,
• rechnergestützt die Messdaten analysiert und dabei eine Geschwindigkeit und Achsabstände (A ... H) des Fahrzeugs (FZ) ermittelt werden,
• rechnergestützt anhand der ermittelten Geschwindigkeit und der ermittelten Achsabstände (A ... H) eine Eigenschaft des spurgeführten Fahrzeugs (FZ) ermittelt wird,
**dadurch gekennzeichnet,**
**dass** in einem Prüfungsschritt
• ein Muster (MT) von Normalachsabständen (A ... H) ermittelt wird, indem jedem der ermittelten Achsabstände ein unter Berücksichtigung einer vorgegebenen Normalgeschwindigkeit berechneter Normalachsabstand zugeordnet wird, und die Normalachsabstände unter Berücksichtigung ihrer Reihenfolge zu dem Muster (MT) zusammengefügt werden,
• das Muster (MT) mit Referenzmustern (RMT) verglichen wird,
• im Falle einer erkannten Übereinstimmung des Musters (MT) mit einem Referenzmuster (RMT) dem Fahrzeug (FZ) eine mit dem Referenzmuster (RMT) verknüpfte Gattung als Eigenschaft zugeordnet wird.

2. Verfahren nach Anspruch 1
**dadurch gekennzeichnet,**
**dass** jeder der Achsabstände unter Berücksichtigung einer für den betreffenden Achsabstand (A ... H) geltenden Einzelgeschwindigkeit des Fahrzeugs (FZ) ermittelt wird.

3. Verfahren nach Anspruch 1,
**dadurch gekennzeichnet,**
**dass** die Einzelgeschwindigkeit als Durchschnittsgeschwindigkeit berechnet wird, die das Fahrzeug (FZ) in der Zeitspanne (T12) zwischen dem Passieren des Achszählers (AZ1 ... AZ2) durch die den Achsabstand definierenden Achsen aufweist.

4. Verfahren nach Anspruch 1,
**dadurch gekennzeichnet,**
**dass** die Durchschnittsgeschwindigkeit aus den beiden durch den Achszähler (AZ1 ... AZ2) anhand der den Achsabstand (A ... H) definierenden Achsen berechneten Geschwindigkeiten der Achsen berechnet wird.

5. Verfahren nach einem der voranstehenden Ansprüche,
**dadurch gekennzeichnet,**
**dass** der Signalverlauf (1 ... 4) vor der Ermittlung der Achsabstände geglättet wird.

6. Verfahren nach einem der voranstehenden Ansprüche,
**dadurch gekennzeichnet,**
**dass** in einem weiteren Prüfungsschritt als eine weitere Eigenschaft des Fahrzeugs (FZ) die Gesamtlänge des Fahrzeugs (FZ) ermittelt wird.

7. Verfahren nach einem der voranstehenden Ansprüche,
**dadurch gekennzeichnet,**
**dass** in einem weiteren Prüfungsschritt gemessene Geschwindigkeiten hinsichtlich Richtung und/oder Betrag und/oder die Gesamtlänge einer Plausibilitätsprüfung unterzogen werden und das Ergebnis der Plausibilitätsprüfung ausgegeben wird.

8. Verfahren nach Anspruch 6 und einem der voranstehenden Ansprüche,
**dadurch gekennzeichnet,**
**dass** für den Prüfungsschritt und/oder den weiteren Prüfungsschritt ein Verfahren des maschinellen Lernens ausgewertet werden.

9. Verfahren nach Anspruch 7 und 8,
**dadurch gekennzeichnet,**
**dass** das Verfahren maschinellen Lernens nur dann angewendet wird, wenn das Ergebnis der Plausibilitätsprüfung positiv ist.

10. Verfahren nach einem der voranstehenden Ansprüche,
**dadurch gekennzeichnet,**
**dass** aus den Messdaten einer Vielzahl von Messungen Wahrscheinlichkeitsdichten für die Eigenschaften ermittelt werden.

11. Vorrichtung zur Bestimmung von Eigenschaften von spurgeführten Fahrzeugen (FZ), umfassend
• mindestens einen Achszähler (AZ1 ... AZ2) zum Erfassen von Messdaten bei Überfahrt der Fahrzeuge (FZ),
• einen Computer (CP), der eingerichtet ist, die Messdaten zu analysieren und dabei eine Geschwindigkeit und Achsabstände (A ... H) des Fahrzeugs (FZ) zu ermitteln, sowie anhand der ermittelten Geschwindigkeit und der ermittelten Achsabstände (A ... H) eine Eigenschaft des Fahrzeugs (FZ) zu ermitteln,
**dadurch gekennzeichnet,**
**dass** der Computer (CP) außerdem dazu eingerichtet ist, bei der Ermittlung der Eigenschaft ein Verfahren nach einem der vorstehenden Ansprüche durchzuführen.

12. Computerprogrammprodukt mit Programmbefehlen zur Durchführung des Verfahrens nach einem der Ansprüche 1 - 10.

13. Bereitstellungsvorrichtung für das Computerprogrammprodukt nach dem letzten voranstehenden Anspruch, wobei die Bereitstellungsvorrichtung das Computerprogrammprodukt speichert und/oder bereitstellt.

## Claims

1. Method for identifying properties of a rail-guided vehicle (FZ), wherein
• an axle counter (AZ1 ... AZ2) detects measurement data as the rail-guided vehicle (FZ) crosses,
• the measurement data is analysed in a computer-assisted manner and a speed and distances between axles (A ... H) of the vehicle (FZ) are ascertained,
• a property of the rail-guided vehicle (FZ) is ascertained in a computer-assisted manner on the basis of the ascertained speed and the ascertained distances between axles (A ... H),
**characterised in that**
in a checking step
• a pattern (MT) of normal distances between axles (A ... H) is ascertained, **in that** a normal distance between axles calculated by taking into account a predefined normal speed is assigned to each of the ascertained distances between axles, and by taking into account their order, the normal distances between axles are merged to form the pattern (MT),
• the pattern (MT) is compared with reference patterns (RMT),
• in the case of an identified conformity of the pattern (MT) with a reference pattern (RMT) a type linked to the reference pattern (RMT) is assigned to the vehicle (FZ) as a property.

2. Method according to claim 1
**characterised in that**
each of the distances between axles is ascertained by taking into account an individual speed of the vehicle (FZ) applicable to the relevant distance between axles (A ... H).

3. Method according to claim 1,
**characterised in that**
the individual speed is calculated as an average speed, which the vehicle (FZ) has in the time period (T12) between the passing of the axle counter (AZ1 ... AZ2) through the axles defining the distance between axles.

4. Method according to claim 1,
**characterised in that**
the average speed is calculated from the two speeds of the axles calculated by the axle counter (AZ1 ... AZ2) on the basis of the axles defining the distance between axles (A ... H).

5. Method according to one of the preceding claims,
**characterised in that**
the signal characteristic (1 ... 4) is smoothed before ascertaining the distances between axles.

6. Method according to one of the preceding claims,
**characterised in that**
in a further checking step the overall length of the vehicle (FZ) is ascertained as a further property of the vehicle (FZ).

7. Method according to one of the preceding claims,
**characterised in that**
in a further checking step, measured speeds are subjected to a plausibility check in respect of direction and/or value and/or the overall length and the result of the plausibility check is output.

8. Method according to claim 6 and one of the preceding claims,
**characterised in that**
a machine learning method is evaluated for the checking step and/or the further checking step.

9. Method according to claim 7 and 8,
**characterised in that**
the machine learning method is only applied when the result of the plausibility check is positive.

10. Method according to one of the preceding claims,
**characterised in that**
probability densities for the properties are ascertained from the measurement data of a large number of measurements.

11. Apparatus for determining properties of rail-guided vehicles (FZ), comprising
• at least one axle counter (AZ1 ... AZ2) for detecting measurement data as the vehicles (FZ) cross,
• a computer (CP), which is adapted to analyse the measurement data and ascertain a speed and distances between axles (A ... H) of the vehicle (FZ), and on the basis of the ascertained speed and the ascertained distances between axles (A ... H), to ascertain a property of the vehicle (FZ),
**characterised in that**
the computer (CP) is also adapted to carry out a method according to one of the preceding claims when ascertaining the property.

12. Computer program product with program commands for carrying out the method according to one of claims 1 - 10.

13. Provisioning apparatus for the computer program product according to the preceding claim, wherein the provisioning apparatus stores and/or provides the computer program product.

## Revendications

1. Procédé de détection de propriétés d'un véhicule (FZ) guidé sur rail, dans lequel
• un compteur (AZ1 ... AZ2) d'essieux détecte des données de mesure pendant le passage du véhicule (FZ) guidé sur rail,
• analyse, en étant assisté par ordinateur, les données de mesure et on en détermine une vitesse et des distances (A ... H) entre essieux du véhicule (FZ),
• on détermine, de manière assistée par ordinateur, à l'aide de la vitesse déterminée et des distances (A ... H) entre essieux déterminées, une propriété du véhicule (FZ) guidé sur rail,
**caractérisé**
**en ce que** dans un stade de contrôle
• on détermine un modèle (MT) de distances (A ... H) normales entre essieux, en associant à chacune des distances entre essieux déterminées, une distance normale entre essieux calculée en tenant compte d'une vitesse normale donnée à l'avance et en rassemblant les distances normales entre essieux, en tenant compte de leur succession, en le modèle (MT),
• on compare le modèle (MT) à des modèles (RMT) de référence,
• dans le cas où l'on détecte une coïncidence du modèle (MT) à un modèle (RMT) de référence, on associe comme propriétés au véhicule (FZ) un genre rattaché au modèle (RMT) de référence.

2. Procédé suivant la revendication 1,
**caractérisé**
**en ce que** l'on détermine chacune des distances entre essieux en tenant compte d'une vitesse individuelle du véhicule (FZ) valant pour la distance (A ... H) entre essieux concernée.

3. Procédé suivant la revendication 1,
**caractérisé**
**en ce que** l'on calcule la vitesse individuelle sous la forme d'une vitesse moyenne, que le véhicule (FZ) a dans le laps (T12) de temps, entre le passage devant le compteur (AZ1 ... AZ2) d'essieux des essieux définissant la distance entre essieux.

4. Procédé suivant la revendication 1,
**caractérisé**
**en ce que** l'on calcule la vitesse moyenne à partir des deux vitesses des essieux, calculées par le compteur (AZ1 ... AZ2) d'essieux à l'aide des essieux définissant la distance entre (A ... H) entre essieux.

5. Procédé suivant l'une des revendications précédentes,
**caractérisé**
**en ce qu'**on lisse la courbe (1 ... 4) du signal avant la détermination des distances entre essieux.

6. Procédé suivant l'une des revendications précédentes,
**caractérisé**
**en ce que**, dans un autre stade de contrôle, on détermine comme autre propriété du véhicule (FZ) une longueur totale du véhicule (FZ) .

7. Procédé suivant l'une des revendications précédentes,
**caractérisé**
**en ce que**, dans un autre stade de contrôle, on soumet des vitesses mesurées en ce qui concerne la direction et/ou la valeur absolue et/ou la longueur totale à un contrôle de vraisemblance et on émet le résultat du contrôle de vraisemblance.

8. Procédé suivant la revendication 6 et suivant l'une des revendications précédentes,
**caractérisé**
**en ce que**, pour le stade de contrôle et/ou l'autre stade de contrôle, on exploite un procédé de l'apprentissage automatique.

9. Procédé suivant la revendication 7 et 8,
**caractérisé**
**en ce que** l'on n'applique le procédé d'apprentissage automatique que si le résultat du contrôle de vraisemblance est positif.

10. Procédé suivant l'une des revendications précédentes,
**caractérisé**
**en ce que** l'on détermine, à partir des données de mesure, une pluralité de mesures des densités de probabilité de la propriété.

11. Installation de détermination de propriétés de véhicules (FZ) guidés sur rail comprenant
• au moins un compteur (AZ1 ... AZ2) d'essieux de détection de données de mesure au passage des véhicules (FZ),
• un ordinateur (CP), qui est agencé pour analyser les données de mesure et en déterminer une vitesse et des distances (A ... H) entre essieux des véhicules (FZ) ainsi que pour déterminer à l'aide de la vitesse déterminée et des distances (A ... H) entre essieux déterminées, une propriété du véhicule (FZ),
**caractérisé**
**en ce que** l'ordinateur (CP) est agencé en outre pour effectuer, lors de la détermination de la propriété, un procédé suivant l'une des revendications précédentes.

12. Produit de programme d'ordinateur ayant des instructions de programme pour effectuer le procédé suivant l'une des revendications 1 à 10.

13. Installation de mise à disposition du produit de programme d'ordinateur suivant la dernière revendication précédente, dans lequel le dispositif de mise à disposition met en mémoire et/ou à disposition le produit de programme d'ordinateur.
